# EUROPEAN PATENT APPLICATION

(11) **EP 2 975 624 A1**
(43) Date of publication of application: **20.01.2016**
(21) Application number: 15155301.3
(22) Date of filing: 17.02.2015
(51) Int. Cl.: H01H 9/16, H03K 17/96, H01H 13/56

(54) **Switch device**

(30) Priority: 14.07.2014 JP 2014144355
(71) Applicant: Panasonic Intellectual Property Management Co., Ltd., Osaka-shi, Osaka 540-6207 (JP)
(72) Inventor: Ueda, Yasuhiro, Chuo-ku, Osaka 540-6207 (JP); Miyake, Tomohiro, Chuo-ku, Osaka 540-6207 (JP); Sasaki, Kosuke, Chuo-ku, Osaka 540-6207 (JP); Higashihama, Hirotada, Chuo-ku, Osaka 540-6207 (JP)
(74) Representative: Appelt, Christian W.

(57) **Abstract**

A switch device includes a main body portion (1), an operating portion (2), a determination portion (3) and a notification portion (4). The main body portion (1) is configured to control power feeding from a power supply (60) to a load (61). The operating portion (2) is selected from two or more types of operating portions and attached to the main body portion (1) detachably. The determination portion (3) is configured to determine whether or not the main body portion (1) and the operating portion (2) are incorrectly paired. The notification portion (4) is configured to issue a notification when the determination portion (3) determines that the main body portion (1) and the operating portion (2) are incorrectly paired.

## Description

### Technical Field

The present invention relates generally to switch devices, and more particularly to a switch device configured to control power feeding from a power supply to a load.

### Background Art

A lighting device including a lighting fixture, a control portion, and an operating portion has been proposed in the related art (e.g., JP Pub. No. 2013-26073 (hereinafter referred to as "Document 1")). The control portion is configured to illuminate, extinguish, or adjust a light source of the lighting fixture upon reception of an instruction from the operating portion. Hereafter, for convenience, the operating portion will be referred to as "the switch device of the related art".

The switch device of the related art includes a casing (a "main body portion" hereafter) and a switch (an "operating portion" hereafter).

Document 1 describes two or more types of main body portions. Document 1 also describes two or more types of operating portions.

In the switch device of the related art, the main body portion and the operating portion may be paired incorrectly during construction, for example.

### Summary of Invention

An object of the present invention is to provide a switch device with which incorrect pairing of a main body portion and an operating portion can be prevented.

A switch device according to an aspect of the present invention includes: a main body portion configured to control power feeding from a power supply to a load; and an operating portion that is selected from two or more types of operating portions and attached to the main body portion detachably. Further, the switch device includes: a determination portion configured to determine whether or not the main body portion and the operating portion are incorrectly paired; and a notification portion configured to issue a notification when the determination portion determines that the main body portion and the operating portion are incorrectly paired.

With the switch device according to the aspect of the present invention, incorrect pairing of the main body portion and the operating portion can be prevented.

### Brief Description of Drawings

The figures depict one or more implementations in accordance with the present teaching, by way of example only, not bay way of limitations. In the figure, like reference numerals refer to the same or similar elements where:
FIG. 1 is a schematic view showing a configuration of a switch device according to a first embodiment;
FIG. 2 is a perspective view showing a condition in which the switch device according to the first embodiment is attached to an attachment frame;
FIG. 3 is an illustrative view illustrating pairings of a main body portion and an operating portion in relation to the switch device according to the first embodiment;
FIG. 4 is a schematic view showing a configuration of a switch device according to a second embodiment; and
FIG. 5 is a schematic view showing a configuration of a switch device according to a third embodiment.

### Description of Embodiments

### (First Embodiment)

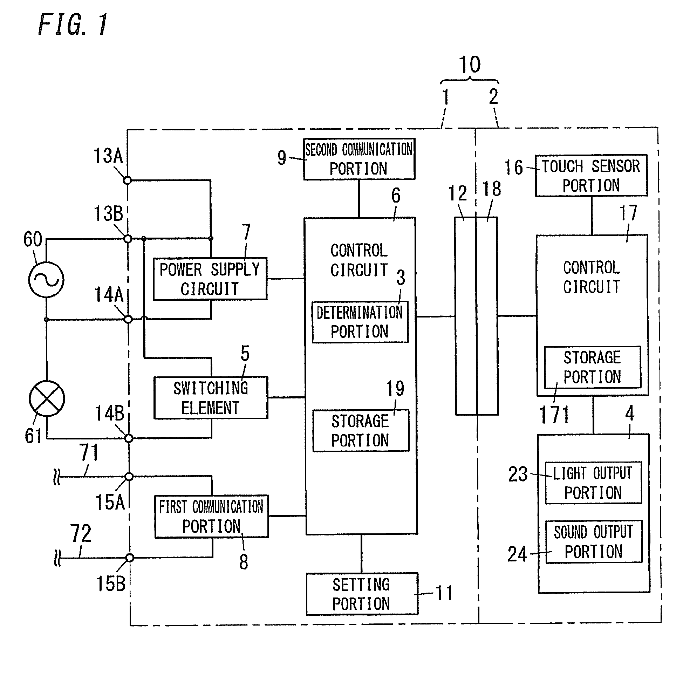

A switch device 10 according to a first embodiment will be described below with reference to FIGS. 1 to 3.

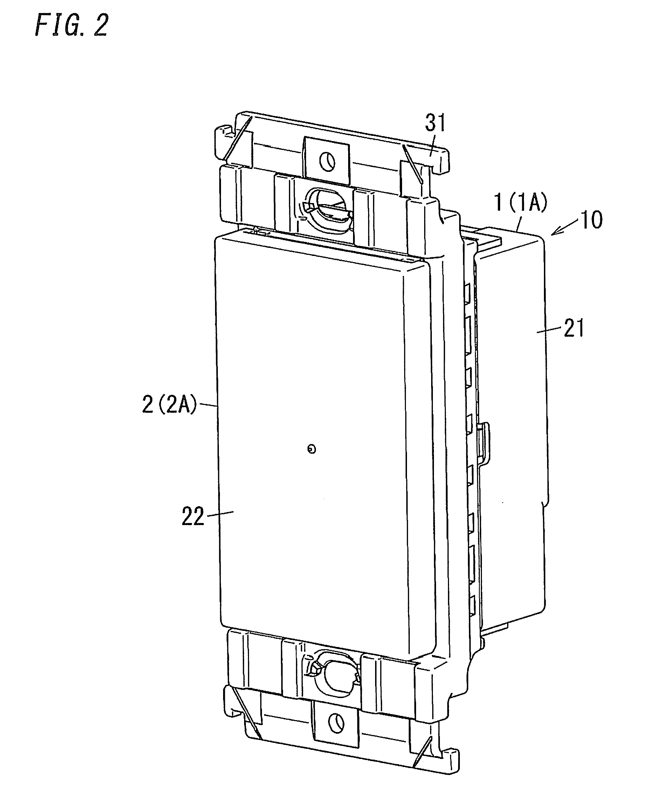

The switch device 10 is configured to control power feeding from a power supply 60 to a load 61. For example, the switch device 10 is disposed so as to be buried in a hole (not shown) formed in advance in a wall through an attachment frame 31 (see FIG. 2). The power supply 60 is a commercial power supply, for example. The load 61 is a lighting fixture, for example. Note that the switch device 10 does not include the power supply 60 and the load 61 as constituent elements. Further, the load 61 is not limited to a lighting fixture, and may be a ventilator, for example.

The switch device 10 includes a main body portion 1 and an operating portion 2.

The main body portion 1 is configured to control power feeding from the power supply 60 to the load 61. In an example, the operating portion 2 is configured to output an operation signal corresponding to an input operation to the main body portion 1, and the main body portion 1 is configured to control power feeding from the power supply 60 to the load 61 in accordance with the operation signal. The main body portion 1 includes a switching element 5, a control circuit (a "first control circuit" hereafter) 6, a power supply circuit 7, a first communication portion 8, a second communication portion 9, a setting portion 11, and a connector (a "first connector" hereafter) 12. The main body portion 1 also includes two power supply terminals 13A, 13B, two load terminals 14A, 14B, two signal terminals 15A, 15B, a first substrate (not shown), and a first casing 21 (see FIG. 2).

The switching element 5 is a bidirectional thyristor, for example. A first main terminal of the switching element 5 is electrically connected to the power supply terminal 13B. A second main terminal of the switching element 5 is electrically connected to the load terminal 14B. A control terminal of the switching element 5 is electrically connected to the first control circuit 6.

The switching element 5 is electrically connected across a series circuit of the power supply 60 and the load 61 via the power supply terminal 13B and the load terminal 14B.

The first control circuit 6 is configured to control the switching element 5. The first control circuit 6 is a microcomputer, for example.

The power supply circuit 7 is configured to convert an alternating current voltage from the power supply 60 into a direct current voltage. The power supply circuit 7 is also configured to output the direct current voltage to the first control circuit 6. The power supply circuit 7 is an AC/DC converter, for example. The power supply circuit 7 is electrically connected to the power supply terminal 13B. The power supply circuit 7 is also electrically connected to the load terminal 14A. Furthermore, the power supply circuit 7 is electrically connected to the first control circuit 6. The power supply circuit 7 is electrically connected across the power supply 60 via the power supply terminal 13B and the load terminal 14A.

Further, the first control circuit 6 is configured to supply the direct current voltage from the power supply circuit 7 to the operating portion 2. In other words, the first control circuit 6 is configured to control power feeding from the main body portion 1 to the operating portion 2.

The power supply terminals 13A, 13B are electrically connected to each other. The power supply terminal 13A is used for a feed wire, for example.

The first communication portion 8 is configured to perform wired communication through two signal wires 71, 72 (a wired signal), for example, as a medium. The first communication portion 8 is electrically connected to the signal terminals 15A, 15B. The first communication portion 8 is also electrically connected to the first control circuit 6. The first communication portion 8 is to be electrically connected to the signal wires 71, 72 via the signal terminals 15A, 15B.

The first communication portion 8 is configured to receive a first control signal transmitted from another switch device (a "second switch device" hereafter) through the signal wires 71, 72 via the signal terminals 15A, 15B, for example. Further, the first communication portion 8 is configured to transmit a second control signal output from the first control circuit 6 to the second switch device via the signal terminals 15A, 15B and the signal wires 71, 72, for example. The first communication portion 8 includes a first transmission circuit (not shown) and a first reception circuit (not shown).

The second communication portion 9 is configured to perform wireless communication through radio waves, for example, as a medium (a "wireless medium" hereafter). The second communication portion 9 is electrically connected to the first control circuit 6.

The second communication portion 9 is configured to receive a third control signal transmitted from a control device (not shown) through the wireless medium, for example. The second communication portion 9 is also configured to transmit a fourth control signal output from the first control circuit 6 to the control device through the wireless medium, for example. The second communication portion 9 includes an antenna (not shown), a second transmission circuit (not shown), and a second reception circuit (not shown).

Note that the first communication portion 8 is configured to perform wired communication with the second switch device, but is not limited to this configuration, and may be configured to perform wireless communication with the second switch device. In this case, the first communication portion 8, similarly to the second communication portion 9, should include an antenna, a second transmission circuit, and a second reception circuit. Further, the second communication portion 9 is configured to perform wireless communication with the control device, but is not limited to this configuration, and may be configured to perform wired communication with the control device. In this case, the second communication portion 9, similarly to the first communication portion 8, should include a first transmission circuit and a first reception circuit.

The setting portion 11 is configured to perform various types of setting on the first control circuit 6. The setting portion 11 is a DIP switch, for example. The setting portion 11 is electrically connected to the first control circuit 6.

The first connector 12 is configured to connect the main body portion 1 and the operating portion 2 to each other electrically and mechanically. The first connector 12 is electrically connected to the first control circuit 6.

The first substrate is a printed board, for example. The switching element 5, the setting portion 11, the first connector 12, the power supply terminals 13A, 13B, the load terminals 14A, 14B, and the signal terminals 15A, 15B are mounted on the first substrate. Further, a plurality of electronic components (not shown) constituting the first control circuit 6, the power supply circuit 7, the first communication portion 8, and the second communication portion 9 are mounted on the first substrate.

The first casing 21 is configured to house the first substrate. The first casing 21 is formed in a box shape from synthetic resin, for example (see FIG. 2). More specifically, the first casing 21 is formed in a rectangular box shape, for example.

The setting portion 11 and the first connector 12 are exposed from a front surface of the first casing 21. The power supply terminals 13A, 13B, the load terminals 14A, 14B, and the signal terminals 15A, 15B are exposed from a rear surface of the first casing 21.

The operating portion 2 is configured to receive operations input by a person, for example. Further, the operating portion 2 is configured to output an operation signal corresponding to an input operation to the main body portion 1, for example. Furthermore, the operating portion 2 is configured to be attached to the main body portion 1 detachably. The operating portion 2 includes a touch sensor portion 16, a control circuit (a "second control circuit" hereafter) 17, a connector (a "second connector" hereafter) 18, a second substrate (not shown), and a second casing 22 (see FIG. 2). The second substrate is a printed board, for example.

The touch sensor portion 16 is a capacitance type touch sensor, for example. The touch sensor portion 16 includes an input portion (not shown) and a sensor circuit (not shown). A capacitance type touch sensor is a sensor that detects contact by or the approach of a part (a finger, for example) of a human body through capacitance variation, for example.

The input portion is formed on a first surface of the second substrate, for example. Further, the input portion is constituted by a plurality of electrodes, for example.

The sensor circuit is configured to detect variation in a stray capacitance (a parasitic capacitance) of each of the plurality of electrodes individually. The sensor circuit is a capacitance type touch sensor IC, for example. The sensor circuit is mounted on the second substrate on a second surface on an opposite side to the first surface.

The sensor circuit determines that a part of a human body has contacted or approached the input portion after detecting an increase in the stray capacitance of at least one of the plurality of electrodes. Note that the input portion may be constituted by a single electrode rather than a plurality of electrodes.

Further, the touch sensor portion 16 is configured to output the aforesaid operation signal to the second control circuit 17 when a part of a human body contacts or approaches the touch sensor portion 16. More specifically, the sensor circuit is configured to output an operation signal corresponding to an operation input into the input portion to the second control circuit 17 after determining that a part of a human body has contacted or approached the input portion.

The second control circuit 17 is configured to output the operation signal from the touch sensor portion 16 to the first control circuit 6 of the main body portion 1. The second control circuit 17 is a microcomputer, for example. The second control circuit 17 is electrically connected to the touch sensor portion 16. Further, the second control circuit 17 is electrically connected to the second connector 18. The second control circuit 17 is mounted on a second surface of the second substrate.

The second connector 18 is configured to connect the main body portion 1 and the operating portion 2 to each other electrically and mechanically. Further, the second connector 18 is configured to be attached to the first connector 12 detachably. In other words, the second connector 18 and the first connector 12 are configured to be attachable and detachable to and from each other. The second connector 18 is mounted on the second surface of the second substrate.

The second casing 22 is configured to house the second substrate. The second casing 22 is formed in a box shape from synthetic resin, for example. More specifically, the second casing 22 is formed in a rectangular box shape, for example.

The second connector 18 is exposed from a rear surface of the second casing 22.

Attachment pieces (not shown) are provided respectively on a right side wall and a left side wall of the second casing 22 in order to attach the operating portion 2 to the main body portion 1. Holding portions (not shown) are provided respectively on a right side wall and a left side wall of the first casing 21 of the main body portion 1 in order to hold the corresponding attachment pieces detachably. Hence, in the switch device 10, the operating portion 2 is attached to the main body portion 1 detachably. In the switch device 10, when the operating portion 2 is attached to the main body portion 1, the second connector 18 of the operating portion 2 is electrically and mechanically connected to the first connector 12 of the main body portion 1.

The second control circuit 17 outputs the operation signal from the touch sensor portion 16 to the first control circuit 6 of the main body portion 1 via the second connector 18 and the first connector 12. The first control circuit 6 controls the switching element 5 on the basis of the operation signal output from the second control circuit 17. As a result, the switch device 10 can control power feeding from the power supply 60 to the load 61.

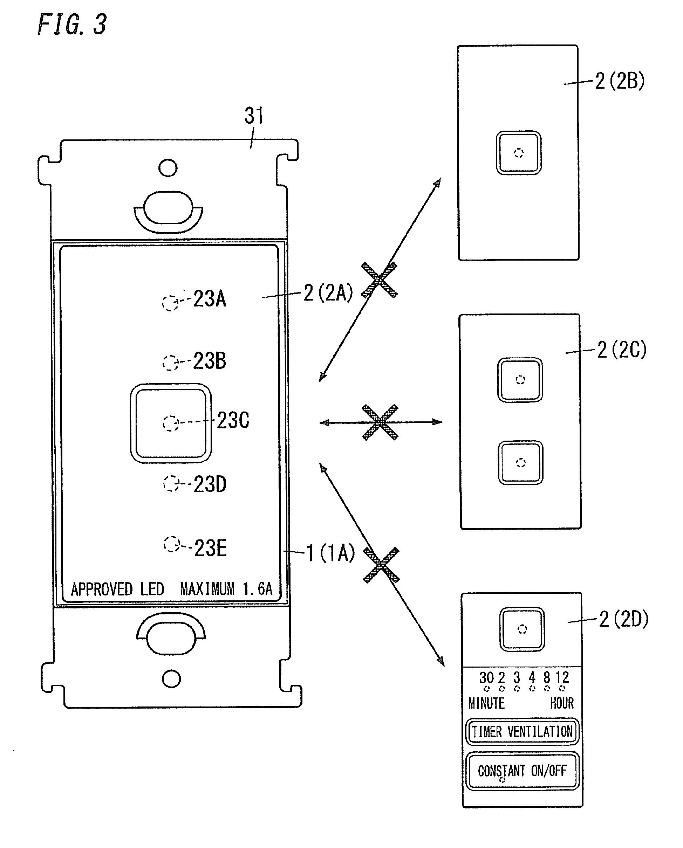

The switch device 10 is configured such that a type of the main body portion 1 and a type of the operating portion 2 are identical. For example, when the switch device 10 is a dimmer, the main body portion 1 is a main body portion 1A for a dimmer (see FIGS. 2 and 3), and the operating portion 2 is an operating portion 2A for a dimmer (see FIGS. 2 and 3). Other examples of types of the main body portion 1, in addition to the main body portion 1A for a dimmer, include a main body portion for a single switch (not shown), a main body portion for a double switch (not shown), a main body portion for a bathroom ventilator switch (not shown), and so on. As shown in FIG. 3, other examples of types of the operating portion 2, in addition to the operating portion 2A for a dimmer, include an operating portion 2B for a single switch, an operating portion 2C for a double switch, an operating portion 2D for a bathroom ventilator switch, and so on. Note that the single switch is a switch that controls power feeding from a power supply to a single load, for example. A double switch is a switch that controls power feeding from a power supply to two loads individually, for example. A bathroom ventilator switch is a switch that controls an operation of a ventilator disposed in a bathroom of a house, for example.

Incidentally, the first control circuit 6 includes a determination portion 3 and a storage portion 19. In other words, the determination portion 3 is provided in the main body portion 1. The main body portion 1 includes the storage portion 19. The switch device 10 includes the determination portion 3.

The determination portion 3 is configured to determine whether or not the type of the main body portion 1 and the type of the operating portion 2 are different. In other words, the determination portion 3 is configured to determine whether or not the main body portion 1 and the operating portion 2 are paired incorrectly. More specifically, for example, when identification data ("first identification data" hereafter) from the operating portion 2 differ from data stored in advance in the storage portion 19, the determination portion 3 determines that the main body portion 1 and the operating portion 2 are paired incorrectly. The data ("first stored data" hereafter) stored in advance in the storage portion 19 are data indicating types of the operating portion 2 to be paired with the main body portion 1, for example.

The first identification data are stored in advance in the operating portion 2 in a first storage portion 171 of the second control circuit 17. The first identification data are data indicating the type of the operating portion 2, for example.

When the first connector 12 and the second connector 18 are electrically and mechanically connected, the second control circuit 17 outputs a first identification signal including the first identification data stored in advance in the first storage portion 171 to the first control circuit 6 of the main body portion 1. When the first identification signal from the second control circuit 17 is input into the first control circuit 6, the determination portion 3 determines whether or not the first identification data included in the first identification signal differ from the first stored data stored in advance in the storage portion 19. Hence, when the first identification data from the operating portion 2 differ from the first stored data stored in advance in the storage portion 19, the determination portion 3 can determine that the main body portion 1 and the operating portion 2 are incorrectly paired.

The first control circuit 6 of the main body portion 1 is configured to output an error signal to the second control circuit 17 of the operating portion 2 when the determination portion 3 determines that the main body portion 1 and the operating portion 2 are incorrectly paired. The error signal is a signal indicating that the main body portion 1 and the operating portion 2 are incorrectly paired.

The operating portion 2 includes a notification portion 4. In other words, the notification portion 4 is provided in the operating portion 2. The switch device 10 includes the notification portion 4.

The notification portion 4 includes a light output portion 23 and a sound output portion 24, for example.

The light output portion 23 includes a plurality of (five, for example) light emitting diodes 23A to 23E (see fig. 3), for example. The light output portion 23 is electrically connected to the second control circuit 17. The second control circuit 17 is configured to illuminate the five light emitting diodes 23A to 23E of the light output portion 23 individually. More specifically, when the main body portion 1 and the operating portion 2 are paired correctly and a light source of the lighting fixture serving as the load 61 is illuminated, for example, the second control circuit 17 illuminates four of the light emitting diodes 23A, 23B, 23D, 23E. Further, when the main body portion 1 and the operating portion 2 are correctly paired and the light source of the lighting fixture is illuminated, for example, the second control circuit 17 extinguishes the remaining light emitting diode 23C. When, on the other hand, the main body portion 1 and the operating portion 2 are paired correctly and the light source of the lighting fixture is extinguished, for example, the second control circuit 17 extinguishes the four light emitting diodes 23A, 23B, 23D, 23E. Further, when the main body portion 1 and the operating portion 2 are correctly paired and the light source of the lighting fixture is extinguished, for example, the second control circuit 17 illuminates the remaining light emitting diode 23C.

The sound output portion 24 includes a sound producing device (not shown) configured to operate a piezoelectric element, for example. Examples of the sound producing device include a piezoelectric diaphragm, a piezoelectric buzzer, a piezoelectric sounder, and so on. The sound output portion 24 is electrically connected to the second control circuit 17. The second control circuit 17 is configured to drive the sound producing device of the sound output portion 24. The second control circuit 17 drives the sound producing device of the sound output portion 24 when the aforesaid operation signal is input therein from the touch sensor portion 16, for example. Accordingly, in the switch device 10, a notification that a part of a human body has contacted or approached the input portion of the touch sensor portion 16 can be issued by a sound (an "operation sound" hereafter) from the sound producing device.

Incidentally, the notification portion 4 is configured to issue a notification when the determination portion 3 determines that the main body portion 1 and the operating portion 2 are incorrectly paired. The notification for indicating that the main body portion 1 and the operating portion 2 are incorrectly paired is to be issued. More specifically, the notification portion 4 is configured to issue a notification that the main body portion 1 and the operating portion 2 are incorrectly paired through the light emitting diode 23C of the light output portion 23.

For example, when the error signal from the first control circuit 6 has been input into the second control circuit 17 and the light source of the lighting fixture is extinguished, the second control circuit 17 extinguishes the light emitting diode 23C. In other words, when the main body portion 1 and the operating portion 2 are incorrectly paired and the light source of the lighting fixture is extinguished, the second control circuit 17 extinguishes the light emitting diode 23C. Hence, in the switch device 10, the notification that the main body portion 1 and the operating portion 2 are incorrectly paired can be issued through the light emitting diode 23C of the light output portion 23. In other words, in the switch device 10, a notification that the main body portion 1 and the operating portion 2 are incorrectly paired can be issued through the notification portion 4. With the switch device 10, therefore, incorrect pairing of the main body portion 1 and the operating portion 2 during construction, for example, can be prevented.

The notification portion 4 is configured to issue, through the light output portion 23, a notification that the main body portion 1 and the operating portion 2 are incorrectly paired. However, the notification portion 4 is not limited to this configuration, and may be configured to issue a notification that the main body portion 1 and the operating portion 2 are incorrectly paired, through the sound output portion 24. In this case, the second control circuit 17 may drive the sound producing device of the sound output portion 24 when, for example, the main body portion 1 and the operating portion 2 are incorrectly paired and the light source of the lighting fixture is extinguished. Accordingly, in the switch device 10, a notification that the main body portion 1 and the operating portion 2 are incorrectly paired can be issued by a sound (a "notification sound" hereafter) from the sound producing device. Note that the notification sound and the operation sound are preferably set to be different types of sounds.

Furthermore, the notification portion 4 may be configured to issue a notification that the main body portion 1 and the operating portion 2 are incorrectly paired, through both the light output portion 23 and the sound output portion 24.

The first control circuit 6 of the main body portion 1 is configured to output the error signal to the second control circuit 17 of the operating portion 2 when the determination portion 3 determines that the main body portion 1 and the operating portion 2 are incorrectly paired. However, the first control circuit 6 is not limited to this configuration, and may be configured to halt power feeding from the main body portion 1 to the operating portion 2 when the determination portion 3 determines that the main body portion 1 and the operating portion 2 are incorrectly paired. In this case, in the switch device 10, the operating portion 2 does not operate after the operating portion 2 is attached to the main body portion 1, and therefore a notification that the main body portion 1 and the operating portion 2 are incorrectly paired can be issued through the operating portion 2. As a result, with the switch device 10, incorrect pairing of the main body portion 1 and the operating portion 2 during construction, for example, can be prevented.

The determination portion 3 is configured to determine that the main body portion 1 and the operating portion 2 are incorrectly paired when the first identification data from the operating portion 2 differ from the first stored data stored in advance in the storage portion 19. However, the determination portion 3 is not limited to this configuration, and may be configured to determine that the main body portion 1 and the operating portion 2 are incorrectly paired when a pushbutton switch that is exposed from the front surface of the first casing 21 of the main body portion 1, for example, is not pushed by a projecting portion provided on the rear surface of the second casing 22 of the operating portion 2. In this case, the determination portion 3 is electrically connected to the pushbutton switch.

Further, the determination portion 3 may be configured to determine whether or not the main body portion 1 or the operating portion 2 is an official product (a genuine product). For example, the determination portion 3 provided in the main body portion 1 may be configured to determine whether or not the operating portion 2 is an official product. In this case, the determination portion 3 may determine that the operating portion 2 is not an official product when, for example, the first identification data included in the first identification signal differ from the first stored data stored in advance in the storage portion 19. When the determination portion 3 determines that the operating portion 2 is not an official product, the first control circuit 6 halts power feeding from the main body portion 1 to the operating portion 2, for example. Accordingly, in the switch device 10, the unauthorized operating portion 2 does not operate after the unofficial operating portion 2 is attached to the main body portion 1, and therefore a situation in which the unofficial operating portion 2 is attached to the main body portion 1 can be prevented. Note that the first identification data included in the first identification signal that is output from the official operating unit 2 are preferably encoded.

The determination portion 3 does not have to be configured to determine that the operating portion 2 is not an official product when the first identification data included in the first identification signal differ from the first stored data stored in advance in the storage portion 19. The determination portion 3 may be configured to determine that the operating portion 2 is not an official product when the first identification signal is not input into the first control circuit 6 within a first predetermined period following a point at which the first connector 12 and the second connector 18 are connected. Further, the determination portion 3 may be configured to determine that the operating portion 2 is not an official product when the first identification signal is not input into the first control circuit 6 following the elapse of a second predetermined period after the first connector 12 and the second connector 18 are connected. Furthermore, the determination portion 3 may be configured to determine that the operating portion 2 is not an official product when the first connector 12 and the second connector 18 are connected but prescribed data prescribed in advance are not included in the first identification signal input into the first control circuit 6. Note that the prescribed data included in the first identification signal output from the official operating portion 2 are preferably encoded.

Note that although the operating portion 2 includes the touch sensor portion 16, the operating portion 2 need not include the touch sensor portion 16. For example, when the switch device 10 is a dimmer, the operating portion 2 may include a dimmer knob (not shown) instead of the touch sensor portion 16. When the operating portion 2 includes a dimmer knob in place of the touch sensor portion 16, the switch device 10 need not include the sound output portion 24 of the notification portion 4.

The switch device 10 according to the first embodiment, described above, includes the main body portion 1 configured to control power feeding from the power supply 60 to the load 61, and the operating portion 2 that is selected from two or more types operating portions and attached to the main body portion 1 detachably. Further, the switch device 10 includes the determination portion 3 configured to determine whether or not the main body portion 1 and the operating portion 2 are incorrectly paired, and the notification portion 4 configured to issue a notification when the determination portion 3 determines that the main body portion 1 and the operating portion 2 are incorrectly paired. In the switch device 10, therefore, a notification that the main body portion 1 and the operating portion 2 are incorrectly paired can be issued by the notification portion 4. Hence, with the switch device 10, incorrect pairing of the main body portion 1 and the operating portion 2 during construction, for example, can be prevented.

As described above, the operating portion 2 preferably includes the touch sensor portion 16. As a result, a so-called touch operation, i.e. an operation performed simply by a gentle touch with a fingertip, for example, can be performed on the switch device 10.

As described above, the determination portion 3 is preferably provided in the main body portion 1. Hence, in the switch device 10, the determination as to whether or not the main body portion 1 and the operating portion 2 are incorrectly paired can be made by the determination portion 3. Accordingly, in the switch device 10, when the main body portion 1 and the operating portion 2 are incorrectly paired, a notification that the main body portion 1 and the operating portion 2 are incorrectly paired can be issued by the notification portion 4. As a result, in the switch device 10, incorrect pairing of the main body portion 1 and the operating portion 2 during construction, for example, can be prevented.

As described above, the main body portion 1 preferably includes the storage portion 19. As described above, the determination portion 3 is preferably configured to determine that the main body portion 1 and the operating portion 2 are incorrectly paired when the first identification data from the operating portion 2 differ from the first stored data stored in advance in the storage portion 19. Hence, in the switch device 10, the determination as to whether or not the main body portion 1 and the operating portion 2 are incorrectly paired can be made by the determination portion 3. Accordingly, in the switch device 10, when the main body portion 1 and the operating portion 2 are incorrectly paired, a notification that the main body portion 1 and the operating portion 2 are incorrectly paired can be issued by the notification portion 4. As a result, in the switch device 10, incorrect pairing of the main body portion 1 and the operating portion 2 during construction, for example, can be prevented.

As described above, the notification portion 4 is preferably provided in the operating portion 2. Hence, in the switch device 10, the notification that the main body portion 1 and the operating portion 2 are incorrectly paired can be issued by the notification portion 4. As a result, in the switch device 10, incorrect pairing of the main body portion 1 and the operating portion 2 during construction, for example, can be prevented.

In an embodiment, each of the two or more types of operating portions 2 includes a storage portion 171 configured to store its own (2) identification data to be output to the determination portion 3. The main body portion 1 includes a storage portion 19 configured to store identification data of an operating portion 2 to be paired with the main body portion 1. The determination portion 3 is configured to determine that when identification data from a storage portion 171 of an operating portion 2, paired with the main body portion 1, of the two or more types of operating portions 2 differ from the identification data stored in the storage portion 19 of the main body portion 1, the main body portion 1 and the operating portion 2 paired with the main body portion 1 are incorrectly paired.

In an embodiment, the main body portion 1 includes a first control circuit 6 and a first connector 12. The first control circuit 6 includes the storage portion 19 of the main body portion 1 and the determination portion 3. The first connector 12 is electrically connected to the first control circuit 6. Each of the two or more types of operating portions 2 includes: a second control circuit 17 including a corresponding storage portion 171, and a second connector 18 that is electrically connected to the second control circuit 17. Each of the two or more types of operating portions 2 is configured so that when a corresponding second connector 18 is connected to the first connector 12, a corresponding second control circuit 17 outputs identification data stored in a storage portion 171 of the corresponding second control circuit 17 to the first control circuit 6 via the first and second connectors 12, 18. The first control circuit 6 is configured to determine that when the identification data output from the second control circuit 17 via the first and second connectors 12, 18 differ from the identification data stored in the storage portion 19 of the first control circuit 6, the main body portion 1 and the operating portion 2 of the second connector 18 connected to the first connector 12 are incorrectly paired.

In an embodiment, the main body portion 1 includes a power supply circuit 7 configured to supply electric power to a side of the second connector 18 via the first and second connectors 12, 18 (in the example of FIG. 1, the first control circuit 6 and the first and second connectors 12, 18). The first control circuit 6 is configured to detect that when the power supply circuit 7 supplies electric power to the side of the second connector 18, the first connector 12 is connected to a second connector 18 of the two or more types of operating portions 2.

FIG. 3 illustrates that the main body portion 1 and an operating portion 2A are correctly paired and that the main body portion 1 and each of operating portions 2B to 2D are incorrectly paired. In this case, the identification data stored in the storage portion 171 of the operating portion 2A are the same as the identification data stored in the storage portion 19. On the other hand, identification data stored in each storage portion 171 of the operating portions 2B to 2D differ from the identification data stored in the storage portion 19.

### (Second Embodiment)

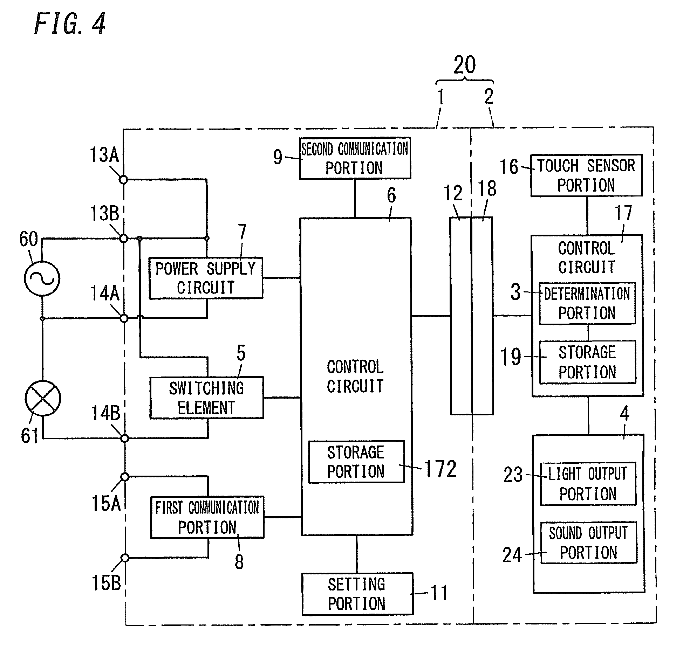

A switch device 20 according to a second embodiment is configured basically identically to the switch device 10 according to the first embodiment. As shown in FIG. 4, however, the switch device 20 differs from the switch device 10 in that a determination portion 3 and a storage portion 19 of the switch device 20 are provided in an operating portion 2 thereof instead of the main body portion 1 of the switch device 10, and so on. Note that in the switch device 20, identical constituent elements to those of the switch device 10 have been allocated identical reference numerals, and description thereof has been omitted as appropriate.

A second control circuit 17 includes the determination portion 3 and the storage portion 19. In other words, the determination portion 3 is provided in the operating portion 2. The operating portion 2 includes the storage portion 19.

The determination portion 3 is configured to determine that a main body portion 1 and the operating portion 2 are incorrectly paired when, for example, identification data ("second identification data" hereafter) from a second storage portion 172 of the main body portion 1 differ from data stored in advance in the storage portion 19. The data ("second stored data" hereafter) stored in advance in the storage portion 19 are data indicating the type of the main body portion 1 to be paired with the operating portion 2, for example.

The second identification data are stored in advance in a second storage portion 172 provided in a first control circuit 6 of the main body portion 1. The second identification data are data indicating a type of the main body portion 1, for example.

The first control circuit 6 is configured to output a second identification signal including the second identification data stored in advance in the second storage portion 172 to the second control circuit 17 of the operating portion 2 when a first connector 12 and a second connector 18 are electrically and mechanically connected.

The second control circuit 17 is configured such that when the second identification signal is input therein from the first control circuit 6, the determination portion 3 determines whether or not the second identification data included in the second identification signal differ from the second stored data stored in advance in the storage portion 19. Hence, when the second identification data from the main body portion 1 differ from the second stored data stored in advance in the storage portion 19, the determination portion 3 can determine that the main body portion 1 and the operating portion 2 are incorrectly paired.

When the determination portion 3 determines that the main body portion 1 and the operating portion 2 are incorrectly paired and a light source of a lighting fixture is extinguished, for example, the second control circuit 17 extinguishes a light emitting diode 23C. Accordingly, in the switch device 20, a notification that the main body portion 1 and the operating portion 2 are incorrectly paired can be issued by the notification portion 4. As a result, in the switch device 20, incorrect pairing of the main body portion 1 and the operating portion 2 during construction, for example, can be prevented.

The switch device 20 according to the second embodiment, described above, includes the main body portion 1 configured to control power feeding from a power supply 60 to a load 61, and the operating portion 2 that is selected from two or more types of operating portions and attached to the main body portion 1 detachably. Further, the switch device 20 includes the determination portion 3 that determines whether or not the main body portion 1 and the operating portion 2 are incorrectly paired, and a notification portion 4 configured to issue a notification when the determination portion 3 determines that the main body portion 1 and the operating portion 2 are incorrectly paired. In the switch device 20, therefore, a notification that the main body portion 1 and the operating portion 2 are incorrectly paired can be issued by the notification portion 4. Hence, with the switch device 20, incorrect pairing of the main body portion 1 and the operating portion 2 during construction, for example, can be prevented.

As described above, the determination portion 3 is preferably provided in the operating portion 2. Hence, in the switch device 20, the determination as to whether or not the main body portion 1 and the operating portion 2 are incorrectly paired can be made by the determination portion 3. Accordingly, in the switch device 20, when the main body portion 1 and the operating portion 2 are incorrectly paired, a notification that the main body portion 1 and the operating portion 2 are incorrectly paired can be issued by the notification portion 4. As a result, in the switch device 20, incorrect pairing of the main body portion 1 and the operating portion 2 during construction, for example, can be prevented.

As described above, the operating portion 2 preferably includes the storage portion 19. As described above, the determination portion 3 is preferably configured to determine that the main body portion 1 and the operating portion 2 are incorrectly paired when the second identification data from the main body portion 1 differ from the second stored data stored in advance in the storage portion 19. Hence, in the switch device 20, the determination as to whether or not the main body portion 1 and the operating portion 2 are incorrectly paired can be made by the determination portion 3. Accordingly, in the switch device 20, when the main body portion 1 and the operating portion 2 are incorrectly paired, a notification that the main body portion 1 and the operating portion 2 are incorrectly paired can be issued by the notification portion 4. As a result, in the switch device 20, incorrect pairing of the main body portion 1 and the operating portion 2 during construction, for example, can be prevented.

In an embodiment, the main body portion 1 includes a storage portion 172 configured to store identification data of the main body portion 1 to be output to the determination portion 3. Each of the two or more types of operating portions 2 includes a storage portion 19 configured to store identification data. At least one storage portion 19 is configured to store the identification data of the main body portion 1. As an example, each of the other of the two or more types of operating portions 2 may be configured to store identification data of other main body portion(s). The determination portion 3 is configured to determine that when the identification data from the storage portion 172 of the main body portion 1 differ from identification data stored in a storage portion 19 of an operating portion 2, paired with the main body portion 1, of the two or more types of operating portions 2, the main body portion 1 and the operating portion 2 paired with the main body portion 1 are incorrectly paired.

In an embodiment, the main body portion 1 includes a first control circuit 6 and a first connector 12. The first control circuit 6 includes the storage portion 172 of the main body portion 1. The first connector 12 is electrically connected to the first control circuit 6. Each of the two or more types of operating portions 2 includes: a second control circuit 17 including a corresponding storage portion 19 and the determination portion 3; and a second connector 18 that is electrically connected to the second control circuit 17. The first control circuit 6 is configured, when the first connector 12 is connected to a second connector 18 of the two or more types of operating portions 2, to output the identification data stored in the storage portion 172 of the first control circuit 6 via the connected first and second connectors 12, 18. Each of the two or more types of operating portions 2 is configured to determine so that when the identification data output from the first control circuit 6 via the first connector 12 and a corresponding second connector 18 differ from identification data stored in a storage portion 19 of a corresponding second control circuit 17, the main body portion 1 and the operating portion 2 of the corresponding second connector 18 are incorrectly paired.

In an example, the main body portion 1 includes a power supply circuit 7 configured to supply electric power to a side of the second connector 18 via the first and second connectors 12, 18 (in the example of FIG. 4, the first control circuit 6 and the first and second connectors 12, 18). Each second control circuit 17 is configured to detect that when the power supply circuit 7 supplies electric power to a side of a corresponding second connector 18, the corresponding second connector 18 is connected to the first connector 12. In this case, each second control circuit 17 is to detect that a corresponding second connector 18 is connected to the first connector 12 when being activated.

### (Third Embodiment)

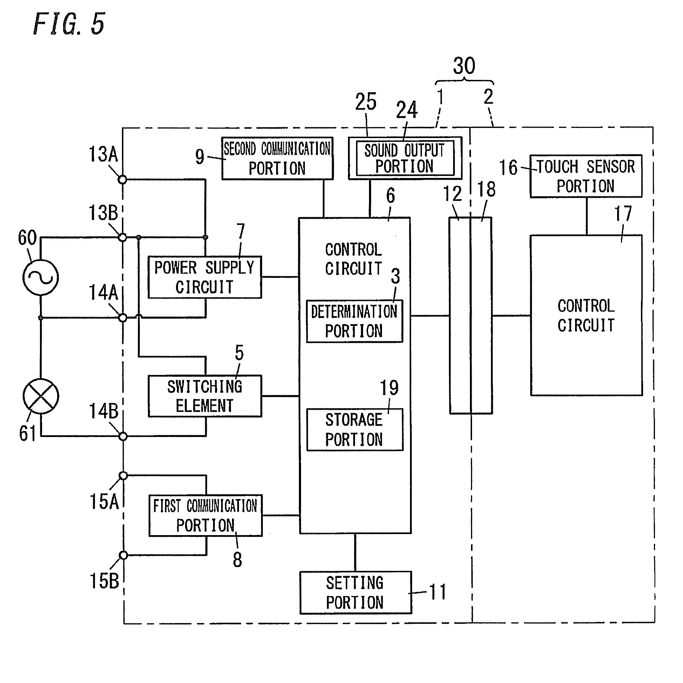

A switch device 30 according to a third embodiment is configured basically identically to the switch device 10 according to the first embodiment. As shown in FIG. 5, however, the switch device 30 differs from the switch device 10 in that instead of providing the notification portion 4 in the operating portion 2, a notification portion 25 of the switch device 30 is provided in a main body portion 1, and so on. Note that in the switch device 30, identical constituent elements to those of the switch device 10 have been allocated identical reference numerals, and description thereof has been omitted as appropriate.

The notification portion 25 is configured to issue a notification when a determination portion 3 determines that the main body portion 1 and an operating portion 2 are incorrectly paired. More specifically, the notification portion 25 includes a sound output portion 24, and the notification portion 25 is configured to issue the notification that the main body portion 1 and the operating portion 2 are incorrectly paired, through the sound output portion 24.

For example, when the main body portion 1 and the operating portion 2 are incorrectly paired and a light source of a lighting fixture is extinguished, the first control circuit 6 drives a sound producing device provided in the sound output portion 24 of the notification portion 25. Hence, in the switch device 30, the notification that the main body portion 1 and the operating portion 2 are incorrectly paired can be issued through the sound output portion 24 of the notification portion 25. In other words, in the switch device 30, the notification that the main body portion 1 and the operating portion 2 are incorrectly paired can be issued through the notification portion 25. As a result, in the switch device 30, incorrect pairing of the main body portion 1 and the operating portion 2 during construction, for example, can be prevented. Note that the configuration in which the notification portion 25 is provided in the main body portion 1 instead of providing the notification portion 4 in the operating portion 2 may be applied to the switch device 20 of the second embodiment. Further, the notification portion 25 includes only the sound output portion 24, but may include both a light output portion 23 and the sound output portion 24.

The switch device 30 is configured such that the notification portion 25 is provided in the main body portion 1. However, the switch device 30 is not limited to this configuration, and may be configured such that the notification portion 25 is provided in the main body portion 1 and the notification portion 4 is provided in the operating portion 2. In this case, the notification portion 25 need include only the sound output portion 24, and the notification portion 4 need include only the light output portion 23. Note that the configuration in which the notification portion 25 is provided in the main body portion 1 and the notification portion 4 is provided in the operating portion 2 may be applied to the switch device 20 of the second embodiment.

The switch device 30 according to the third embodiment, described above, includes the main body portion 1 configured to control power feeding from a power supply 60 to a load 61, and the operating portion 2 that is selected from two or more types of operating portions and attached to the main body portion 1 detachably. Further, the switch device 30 includes the determination portion 3 configured to determine whether or not the main body portion 1 and the operating portion 2 are incorrectly paired, and the notification portion 25 configured to issue a notification when the determination portion 3 determines that the main body portion 1 and the operating portion 2 are incorrectly paired. In the switch device 30, therefore, the notification that the main body portion 1 and the operating portion 2 are incorrectly paired can be issued by the notification portion 25. Hence, with the switch device 30, incorrect pairing of the main body portion 1 and the operating portion 2 during construction, for example, can be prevented.

As described above, the notification portion 25 is preferably provided in the main body portion 1. Hence, in the switch device 30, the notification that the main body portion 1 and the operating portion 2 are incorrectly paired can be issued through the notification portion 25. As a result, in the switch device 30, incorrect pairing of the main body portion 1 and the operating portion 2 during construction, for example, can be prevented.

While the foregoing has described what are considered to be the best mode and/or other examples, it is understood that various modifications may be made therein and that the subject matter disclosed herein may be implemented in various forms and examples, and that they may be applied in numerous applications, only some of which have been described herein. It is intended by the following claims to claim any and all modifications and variations that fall within the true scope of the present teachings.

## Claims

1. A switch device, comprising:
a main body portion (1) configured to control power feeding from a power supply (60) to a load (61);
an operating portion (2) that is selected from two or more types of operating portions (2A, 2B, 2C, 2D) and attached to the main body portion (1) detachably;
a determination portion (3) configured to determine whether or not the main body portion (1) and the operating portion (2) are incorrectly paired; and
a notification portion (4) configured to issue a notification when the determination portion (3) determines that the main body portion (1) and the operating portion (2) are incorrectly paired.

2. The switch device according to claim 1, wherein the operating portion (2) comprises a touch sensor portion (16).

3. The switch device according to claim 1 or 2, wherein the determination portion (3) is provided in the main body portion (1).

4. The switch device according to claim 3, wherein
each of the two or more types of operating portions (2A, 2B, 2C, 2D) comprises a storage portion (171) configured to store its own identification data to be output to the determination portion (3),
the main body portion (1) comprises a storage portion (19) configured to store identification data of an operating portion (2, 2A) to be paired with the main body portion (1), and
the determination portion (3) is configured to determine that when identification data from a storage portion (171) of an operating portion (2), paired with the main body portion (1), of the two or more types of operating portions (2A, 2B, 2C, 2D) differ from the identification data stored in the storage portion (19) of the main body portion (1), the main body portion (1) and the operating portion (2) paired with the main body portion (1) are incorrectly paired.

5. The switch device according to claim 4, wherein
the main body portion (1) further comprises:
a first control circuit (6) including the storage portion (19) of the main body portion (1) and the determination portion (3), and
a first connector (12) that is electrically connected to the first control circuit (6),
each of the two or more types of operating portions (2A, 2B, 2C, 2D) further comprises:
a second control circuit (17) including a corresponding storage portion (171), and
a second connector (18) that is electrically connected to the second control circuit (17),
each of the two or more types of operating portions (2A, 2B, 2C, 2D) is configured so that when a corresponding second connector (18) is connected to the first connector (12), a corresponding second control circuit (17) outputs identification data stored in a storage portion (171) of the corresponding second control circuit (17) to the first control circuit (6) via the first and second connectors (12, 18), and
the first control circuit (6) is configured to determine that when the identification data output from the second control circuit (17) via the first and second connectors (12, 18) differ from the identification data stored in the storage portion (19) of the first control circuit (6), the main body portion (1) and the operating portion (2) of the second connector (18) connected to the first connector (12) are incorrectly paired.

6. The switch device according to claim 1 or 2, wherein the determination portion (3) is provided in the operating portion (2).

7. The switch device according to claim 6, wherein
the main body portion (1) comprises a storage portion (172) configured to store identification data of the main body portion (1) to be output to the determination portion (3),
each of the two or more types of operating portions (2A, 2B, 2C, 2D) comprises a storage portion (19) configured to store identification data, at least one storage portion (2) being configured to store the identification data of the main body portion (1), and
the determination portion (1) is configured to determine that when the identification data from the storage portion (172) of the main body portion (1) differ from identification data stored in a storage portion (19) of an operating portion (2), paired with the main body portion (1), of the two or more types of operating portions (2A, 2B, 2C, 2D), the main body portion (1) and the operating portion (2) paired with the main body portion (1) are incorrectly paired.

8. The switch device according to claim 7, wherein
the main body portion (1) further comprises:
a first control circuit (6) including the storage portion (172) of the main body portion (1), and
a first connector (12) that is electrically connected to the first control circuit (6),
each of the two or more types of operating portions (2A, 2B, 2C, 2D) further comprises:
a second control circuit (17) including a corresponding storage portion (19) and the determination portion (3), and
a second connector (18) that is electrically connected to the second control circuit (17),
the first control circuit (6) is configured, when the first connector (12) is connected to a second connector (18) of the two or more types of operating portions (2A, 2B, 2C, 2D), to output the identification data stored in the storage portion (172) of the first control circuit (6) via the connected first and second connectors (12, 18),
each of the two or more types of operating portions (2A, 2B, 2C, 2D) is configured to determine so that when the identification data output from the first control circuit (6) via the first connector (12) and a corresponding second connector (18) differ from identification data stored in a storage portion (19) of a corresponding second control circuit (17), the main body portion (1) and the operating portion (2) of the corresponding second connector (18) are incorrectly paired.

9. The switch device according to any one of claims 1 to 8, wherein the notification portion (4, 23, 24) is provided in the operating portion (2).

10. The switch device according to any one of claims 1 to 9, wherein the notification portion (24, 25) is provided in the main body portion (1).
